# FASCICULE DE BREVET EUROPEEN

(11) **EP 1 192 593 B1**
(45) Date de publication et mention de la délivrance du brevet: **12.11.2003**
(21) Numéro de dépôt: 00938861.2
(22) Date de dépôt: 30.05.2000
(51) Int. Cl.: G06K 19/077

(54) **DISPOSITIF ET PROCEDE DE FABRICATION DE DISPOSITIFS COMPRENANT AU MOINS UNE PUCE MONTEE SUR UN SUPPORT**
VORRICHTUNG UND HERSTELLUNGSVERFAHREN MIT ZUMINDEST EINEM CHIP AUF EINEM TRÄGER
DEVICE AND METHOD FOR MAKING DEVICES COMPRISING AT LEAST A CHIP MOUNTED ON A SUPPORT

(30) Priorité: 15.06.1999 FR 9907549
(43) Date de publication de la demande: 03.04.2002
(73) Titulaire: Gemplus, 13881 Gémenos Cedex (FR)
(72) Inventeur: CALVAS, Bernard, F-13400 Aubagne (FR); PATRICE, Philippe, Résidence Les Deux Moulin, F-13190 Allauch (FR); FIDALGO, Jean-Christophe, F-13420 Gémenos (FR)
(86) Numéro de dépôt international: FR0001494
(87) Numéro de publication internationale: WO00077731

(56) Documents cités:
- WO-A-98/02921
- FR-A- 2 752 077
- FR-A- 2 756 955

## Description

L'invention concerne un procédé de fabrication de dispositifs composés d'au moins un microcircuit monté sur un support, par exemple pour réaliser une carte à puce.

Dans certains domaines, dont celui des cartes à puce, il est nécessaire de réaliser le montage d'un microcircuit ou puce sur un support relativement mince et flexible. Dans le cas de cartes à puce, il est nécessaire d'une part que la présence de la puce n'occasionne pas une surépaisseur au-delà d'un seuil établi par des normes internationales (actuellement fixé à 50 µm) et d'autre part que le montage de la puce soit suffisamment sûr pour permettre une utilisation durable même lorsque la carte est soumise à des contraintes de pliage et de torsion relativement élevées.

De manière classique, on évite de créer une surépaisseur trop importante en logeant la puce dans une cavité ménagée à cet effet dans l'épaisseur du support.

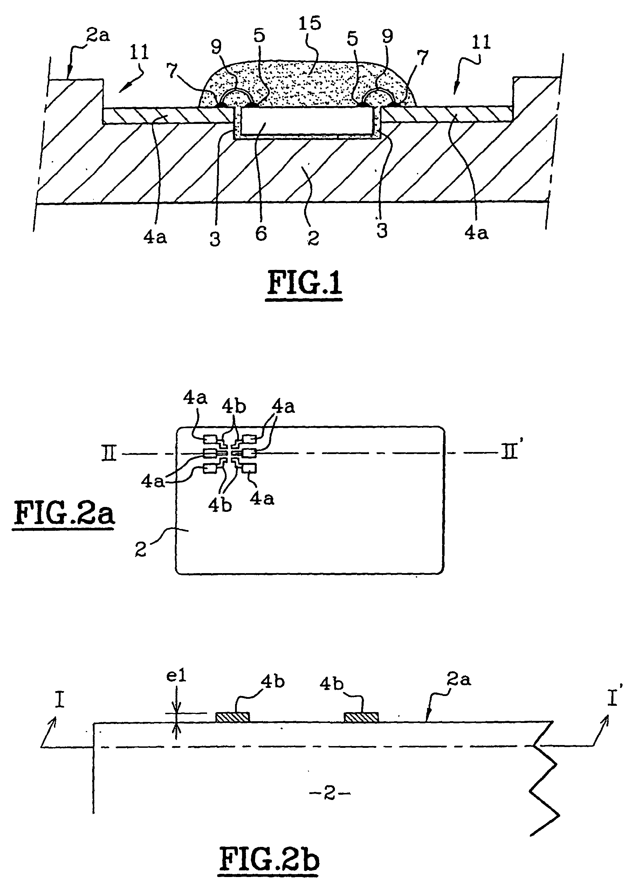

La figure 1 montre schématiquement un exemple connu de montage d'une puce 6 sur un support 2 destiné à constituer une carte à puce. La puce 6 est logée presque intégralement dans une cavité 3 de manière à ce que son épaisseur soit comprise dans celle du support 2. La puce 6 présente un ensemble de plots de connexion 5 sur les bords de sa surface tournée vers l'extérieur de la cavité 3. Ces plots 5 sont reliés à des contacts respectifs 7 du support par des fils 9. Les contacts 7 peuvent être situés au fond de la cavité, ou à un niveau intermédiaire dans une zone de renfoncement 11 autour de la cavité, comme dans l'exemple illustré. Ces contacts 7 sont à leur tour reliés électriquement à des plages de contact 4a destinées à permettre une connexion ohmique avec un lecteur de cartes. Ces plages de contact 4a sont logées intégralement dans le renfoncement 11 afin que leur épaisseur soit aussi contenue dans celle du support 2.

Pour protéger l'ensemble, on forme un enrobage de matériau protecteur 15 recouvrant toute la zone occupée par la cavité 3, les fils 9 et une portion des bords internes des plages de contact 11.

Cette technique classique souffre de plusieurs inconvénients. Premièrement, l'opération consistant à relier électriquement les plots de connexion 5 de la puce 6 aux contacts 7 nécessite l'utilisation de fils 9 très fins et délicats, formant ainsi des points de fragilité. Par ailleurs, les opérations de soudage de ces fils 9 nécessitent un outillage important et un temps non négligeable.

Par ailleurs, la formation de la cavité 3 demande une étape d'usinage qui est à la fois coûteuse et fragilisante pour la carte.

Au vu de ces problèmes, l'invention propose le montage d'au moins un circuit actif tel qu'une puce, sur un support permettant de s'affranchir de la nécessité de former une cavité dans le support sans créer pour autant une surépaisseur rédhibitoire.

A cette fin, la présente invention propose de solidariser à un support une puce réalisée sous forme mince, collée à un substrat. Ce type de puce présente une minceur exceptionnelle, conférant ainsi une certaine souplesse mécanique. La puce est collée sur un substrat au stade de la fabrication, le substrat servant entre autres pour la rigidification durant les diverses étapes de la fabrication de la puce. Le document WO9802921 expose la technologie permettant de réaliser ces puces, connue sous le terme de SOI ("silicon on insulator", en anglais) dont l'épaisseur hors tout (substrat du circuit actif plus bossages de connexion) est de l'ordre d'une dizaine de microns. Toutefois, la technologie SOI est délicate lorsqu'il s'agit de solidariser la puce sur un support. Les techniques utilisées à ce jour comprennent des étapes de manipulation de la puce mince hors de son substrat rigidifiant afin de la positionner et de la solidariser sur des points de connexion du support. Il se pose alors le problème d'une part du décollage de la puce de son substrat et de la manipulation de la puce nue pour la fixer sur son support définitif.

Ainsi, le document WO9802921 Kopin évoqué plus haut décrit la fabrication de circuits intégrés hautement flexibles qui peuvent tolérer les flexion, tensions et compressions...en maintenant l'intégrité du circuit. Ce circuit est transféré lors de sa fabrication, depuis un second substrat vers un substrat final, qui est appelé "substrat rigidifiant" dans la demande de brevet.

Citons des documents à rapprocher de l'invention.

Le document FR2752077 Solaic décrit une carte à circuit intégré comportant un corps dans lequel est noyé l'antenne reliée à un module, lui même reçu dans une cavité.

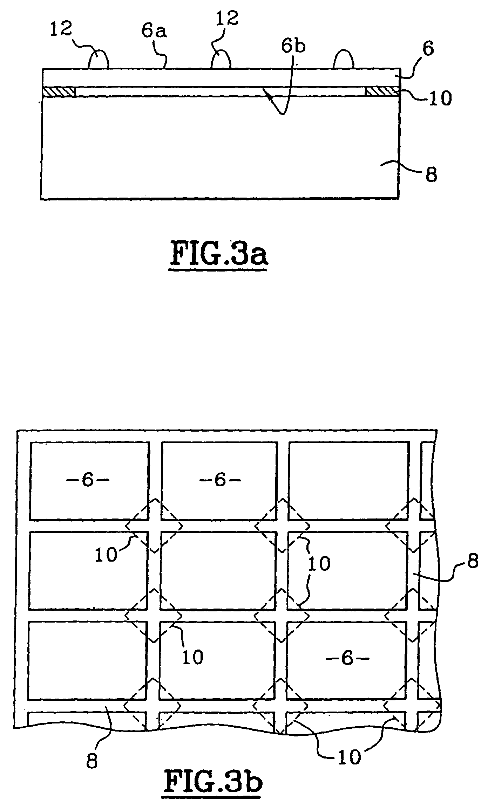

Le document FR2756955 Schlumberger décrit un circuit électronique pour carte de mémoire, avec une feuille support où est réalisée une antenne. Une pastille semi conductrice est montée sur les bornes de l'antenne. Ce circuit subit ensuite une plastification, comme illustré sur les figures 3 à 8, par laminage.

Pour résoudre ces problèmes, l'invention est définie par les revendications indépendentes où le préambule de la revendication 12 corresponds au document WO 98 02921.

L'invention permet de manipuler les puces issues de la technologie SOI tout en gardant le substrat initial. Ce substrat est notamment maintenu lorsque la puce est solidarisée à ses éléments de connexion du support. De la sorte, les risques d'endommagement de la puce lors du montage sont réduits au minimum.

L'invention est intéressante lorsque l'on souhaite préserver l'avantage de la minceur permise par ces substrats minces en les associant à des supports de faible épaisseur. Ainsi, l'invention permet l'assemblage d'une ou de plusieurs puces minces directement sur la surface du support et d'obtenir ainsi des circuits exploitables minces sans avoir à former de cavité dans le support.

Dans un mode de réalisation, il est également prévu de réaliser l'interface de communication sur une portion de surface située dans le plan général de ladite face du support, c'est-à-dire que l'on forme l'interface de communication en surépaisseur sur la surface du support, et donc sans former de renfoncement du type illustré à la figure 1.

On obtient alors un dispositif, tel une carte à puce, où tous les éléments rapportés sur le support (interface de communication et puce) sont en surface.

En effet, l'invention permet d'utiliser des puces de très haut degré de minceur, ce qui autorise une surépaisseur admissible pour la métallisation formant l'interface de communication. Dans le cas d'une carte à puce, cette interface de communication peut intégrer des plages de contact pour permettre de relier la carte à un lecteur du type "à contact". Elle peut également être couplée électriquement à une antenne intégrée à la carte pour former une carte "sans contact", l'échange de signaux avec la puce et éventuellement son alimentation électrique s'opérant par voie hertzienne via l'antenne.

Avantageusement, chaque plot est solidarisé avec son élément de connexion respectif par soudage au moyen d'un faisceau laser.

Il est notamment possible grâce à l'invention d'agencer le faisceau laser afin qu'il traverse le substrat de l'ensemble substrat et puce. Autrement dit, on irradie les points de soudage (par exemple des bossages) de la puce à travers le substrat. On remarque à cet effet que les substrats utilisés notamment dans la technologie SOI sont généralement transparents aux longueurs d'onde utilisées pour la soudure par laser, étant généralement à base de verre. La puce elle-même est transparente à l'épaisseur envisagée.

D'autres avantages et caractéristiques de l'invention apparaîtront plus clairement à la lecture de la description qui suit, donnée à titre d'exemple, et en référence au dessins annexés dont :
- la figure 1, déjà décrite, est un schéma en coupe montrant le montage d'une puce dans une cavité d'un support selon l'art antérieur ;
- la figure 2a est une vue de plan partielle d'un support de carte à puce comportant une interface de communication ;
- la figure 2b est une vue en coupe selon l'axe II-II' de la figure 2a ;
- la figure 3a est une vue de coupe d'un ensemble comportant une puce collée sur son substrat selon la technologie SOI "flip-chip";
- la figure 3b est une vue en plan d'une plaquette comportant un groupe d'ensembles de la figure 3 avant découpage ;
- la figure 4 est une vue en coupe de l'ensemble représenté à la figure 3a positionné sur son support ;
- la figure 5 représente une étape de soudure de l'ensemble représenté à la figure 3a sur son support ;
- la figure 6 représente une étape de soudure de l'ensemble représenté à la figure 3a sur son support selon une variante de la figure 5 ;
- la figure 7 est une vue de coupe partielle d'un dispositif composé d'une puce montée sur son support à l'issue du procédé selon un mode de réalisation de l'invention ;
- la figure 8 est une vue de plan partielle d'un support avec son interface de communication destinée à réaliser une carte à puce sans contact ; et
- la figure 9 est une vue en coupe selon l'axe IIX-IIX' de la figure 8 montrant l'étape de solidarisation d'un ensemble comportant une puce collée sur son substrat selon la technologie SOI "flip-chip".

La figure 2a représente un support 2 qui, dans l'exemple considéré consiste en une carte en plastique destinée à constituer une carte à puce selon les normes dimensionnelles établies, par exemple la norme ISO 7810.

A cette fin, on crée à la zone du support 2 destinée à recevoir un microcircuit (désigné ci-après par le terme "puce") un ensemble de plots formant, ou reliés à une interface de communication 4. Une telle interface de communication 4 peut, selon les cas, servir à :
- relier due entrées et sorties de la puce avec l'extérieur, notamment les lecteurs de cartes ; et/ou
- assurer les interconnexions nécessaires entre la puce et des éléments réalisés au niveau du support. Ces éléments peuvent être une antenne intégrée au support 2 de manière à constituer une carte dite "carte sans contact", connue en elle-même, ou d'autres éléments de circuit intégrés à la carte (par exemple une ou plusieurs autres puces), ou encore une source d'alimentation électrique.

Dans l'exemple illustré, l'interface de communication 4 est formée d'une part de plots d'interconnexion 4a permettant de relier par contact ohmique un équipement extérieur avec la puce et d'autre part de pistes 4b qui reliant les plots d'interconnexion à la puce, comme il sera décrit plus loin.

L'interface de communication 4 est formée sur une portion de surface d'une des faces 2a du support 2 se situant sur le même plan que le reste de cette face 2a, comme le montre la figure 2b. Autrement dit, la portion de surface contenant l'interface de communication 4 n'est pas en retrait du plan de la face 2a, comme cela serait le cas avec une cavité ou un renfoncement. Ainsi, l'interface de communication 4 forme une sur-épaisseur vis-à-vis de la surface 2a du support 2.

On réalise l'interface de communication 4 selon des techniques qui permettent le dépôt de matériau électriquement conducteur destiné à former cette interface avec une faible épaisseur e1 (figure 2b). A titre d'exemple, l'épaisseur e1 de l'interface de communication 4 est de l'ordre de 5 à 15 microns.

Plusieurs techniques connues en elles-mêmes peuvent être envisagées pour réaliser cette interface de communication 4. Dans l'exemple, l'interface de communication 4 est réalisée par impression, au moyen d'une encre conductrice contenant des particules d'argent, de plaques conductrices ayant la configuration préformée des plots 4a et des pistes 4b. On peut également envisager de réaliser l'interface de communication 4 par métallisation selon des techniques de sérigraphie, de dépôt sous vide, etc. Le matériau conducteur utilisé est typiquement à base de cuivre, de nickel ou d'aluminium. Ce matériau peut être incorporé dans un liant adapté à la technique utilisée.

La puce est réalisée selon une technologie permettant d'obtenir un substrat très mince de manière à ce que la puce puisse être déposée sur l'interface de communication 4.

Dans le présent mode de réalisation, le microcircuit est réalisé selon la technologie SOI c'est-à-dire de silicium sur isolant ("silicon on insulator", en anglais), permettant d'obtenir des puces particulièrement minces. Les aspects spécifiques à cette technologie sont connus, notamment par le document brevet WO-A-98/02921.

Un exemple d'un ensemble comportant une puce et son substrat selon cette technologie SOI est représenté aux figures 3a et 3b.

La figure 3a est une vue en coupe longitudinale qui représente une puce 6 montée sur un substrat isolant 8, dans ce cas du verre. La puce 6 est maintenue solidaire sur le substrat de verre 8 par des plots d'adhésif 10. Ainsi, la puce 6, son substrat isolant 8 et les plots d'adhésif 10 constituent un ensemble, découpé à partir d'une tranche (cf. figure 3b).

Comme le montre plus clairement la figure 3b qui représente une vue de plan d'un ensemble de puces 6 sur le substrat 8, les plots d'adhésif 10 ne retiennent la puce que par les coins de celle-ci. En dehors des bords du substrat de verre 8, chaque plot d'adhésif 10 présente une forme rectangulaire dont les côtés sont tournés de 45° par rapport aux côtés des puces 6, et retient sur le substrat 8 quatre coins regroupés de quatre puces respectives 6. De ce fait, les puces 6 ne sont maintenues sur le substrat de verre 8 que par leurs coins.

La face 6a de la puce 6 à l'opposé de celle 6b en vis-à-vis du substrat du verre 8 comporte une série de bossages conducteurs 12 en légère protubérance de cette face 6a. Les bossages conducteurs 12, connus généralement par le terme anglo-saxon de "bumps", constituent les points d'interconnexion entre les circuits de la puce 6 et l'extérieur. Ces bossages 12 ont une forme généralement ogivale permettant une pénétration dans un matériau en phase ramollie, par exemple par soudure.

Dans l'exemple, une seule puce 6 est destinée à être reçue sur l'interface de communication 4 précitée. La disposition des bossages 12 correspond à celle des pistes conductrices 4b ou d'une portion des plots d'interconnexion 4a.

Chaque puce 6 est alors découpée de l'ensemble de puces avec la portion de substrat de verre 8 et le plot d'adhésif 10 située directement sous la puce 6. On obtient ainsi un ensemble découpé comportant la puce 6, des portions d'adhésif 10 aux coins de la puce et une portion de substrat de verre 8 sensiblement aux dimensions de la puce (figure 3a).

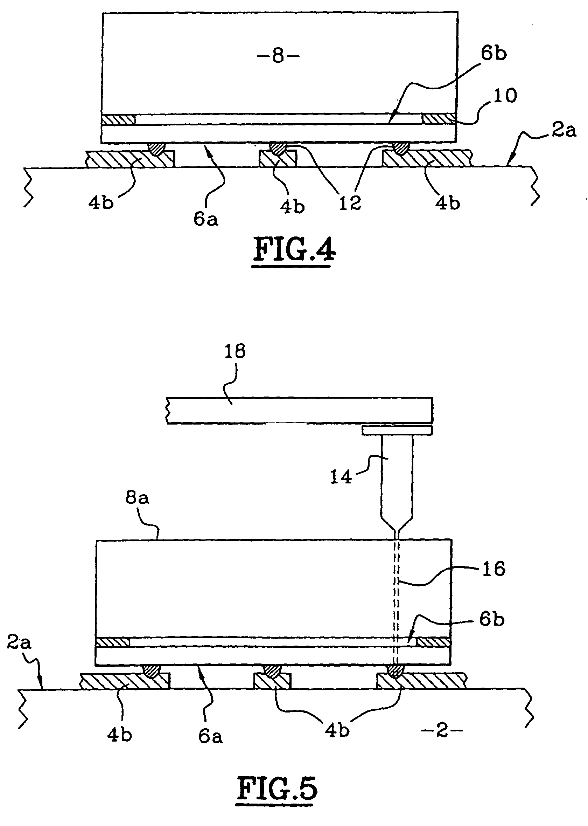

Comme le montre la figure 4, cet ensemble est positionné sur l'interface de communication 4 réalisée sur le support 2, avec les bossages 12 alignés avec les portions des pistes 4b respectives pour réaliser les interconnexions nécessaires.

On remarquera que lorsque la puce 6 est positionnée sur son support définitif (qui est ici le support plastique 2 qui constitue le corps de la carte à puce), la face 6a précédemment définie se trouve non plus tournée vers l'extérieur, mais en vis-à-vis de ce support 2. Autrement dit, elle subit un retournement de 180° entre sa configuration juste après sa fabrication et son positionnement définitif. Cette technique de retournement de la puce 6 par rapport à son substrat d'origine est connu sous le terme anglo-saxon de "flip-chip".

Une fois la puce 6 correctement positionnée, on procède à la fixation des bossages 12 par rapport aux points de connexion respectifs (qui sont ici des portions de pistes 4b).

Dans le mode de réalisation préféré de l'invention, cette fixation est réalisée par application d'énergie à travers le substrat 8 d'origine de la puce 6. Cette énergie est fournie par un laser 14 qui transmet un faisceau 16 dirigé contre la face 8a du substrat tournée vers l'extérieur. Le faisceau 16 traverse toute l'épaisseur du substrat 8 et l'épaisseur de la puce 6 sur un axe contenant un bossage 12, de manière à transférer de l'énergie thermique à celle-ci.

Cette énergie thermique absorbée au niveau du bossage 12 permet la fusion du bossage 12, celui-ci. étant réalisé dans un alliage de métaux facilement fusible tel que étain, plomb.

Lorsqu'un bossage est ainsi soudé, le laser 14 est déplacé pour se mettre dans l'axe du bossage suivant, et pour procéder au soudage de celui-ci.

Chaque bossage 12 est ainsi soudé par le faisceau laser 16 sur son point de connexion correspondant 4b de l'interface de communication 4.

En variante, il est possible de réaliser des plots de soudure aux points 4b de l'interface de communication 4 destinés à recevoir les bossages respectifs 12. Ces plots sont alors réalisés en un matériau fusible sous l'énergie thermique transférée par le faisceau laser 16, à travers les bossages respectifs 12 pour souder ces derniers.

Dans l'exemple, le verre constitutif du substrat 8 est transparent aux longueurs d'onde des faisceaux lasers habituellement utilisés pour la microsoudure. Il est notamment possible d'utiliser pour la soudure un laser du type YAGNd émettant à une longueur d'onde de 1,06 µm.

Le laser 14 peut être monté sur un robot positionneur 18 permettant d'aligner un faisceau laser 16 successivement avec chaque bossage 12 de la puce 6 maintenue en position sur son support 2.

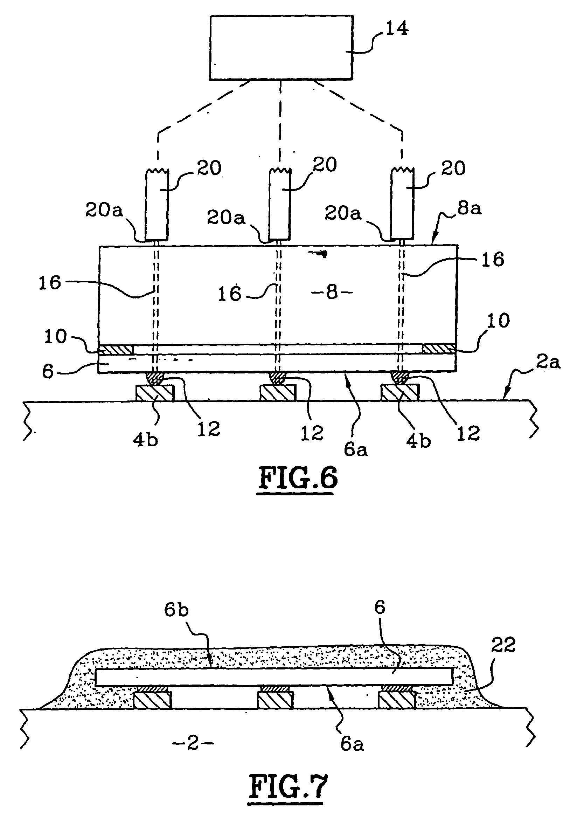

La figure 6 représente une variante selon laquelle plusieurs soudures de bossages 12 sont réalisées simultanément depuis un laser 14 grâce à un ensemble de chemins optiques 20 transportant chacun un faisceau laser 16 vers des positions respectives en alignement avec un bossage 12. Les chemins optiques 20 peuvent être matérialisés par des fibres optiques. Dans ce cas, au moins une fibre optique est positionnée perpendiculairement en regard de la face 8a du substrat de verre 8 (celle tournée vers l'extérieure en position d'assemblage) à l'aplomb de chaque bossage 12. L'énergie transmise par les fibres 20 réalise la soudure comme décrit précédemment. La puissance du laser 14 sera adaptée au nombre de chemins optiques utilisés. Eventuellement, il est possible d'utiliser plusieurs sources laser différentes pour alimenter les chemins optiques.

Les extrémités 20a des fibres peuvent être intégrées à l'outil de positionnement et de maintien de la puce vis-à-vis du support 2. Les extrémités 20a des fibres sont disposées selon la configuration des bossages 12 à souder sur l'interface de communication 4. Il est possible de prévoir à cet effet un bâti permettant l'assemblage et le soudage de plusieurs puces 6 sur un même support 2 ou sur différents supports.

Cette variante présente l'avantage de permettre de réaliser toutes les soudures des bossages 12 simultanément.

Une fois les soudures réalisées, on retire le substrat de verre 8 de la puce 6. Cette opération peut être réalisée par pelage du substrat 8, la force de maintient des plots d'adhésif 10 étant sensiblement plus faible que celle des soudures des bossages 12 sur l'interface de connexion.

Il résulte de cette opération que la puce 6 est reliée électriquement et mécaniquement à la surface de support 2. Pour protéger la puce 6, on applique sur la surface exposée 6b de celle-ci une pellicule 22, comme le montre la figure 7. Cette pellicule 22 peut être réalisée par une simple impression de vernis apte à protéger le circuit des contraintes climatiques et mécaniques. L'étendue de la pellicule 22 peut être limitée de manière à ne pas recouvrir les plots d'interconnexion 4a afin que ceux-ci puissent assurer un contact ohmique. Cependant, il est envisageable de former la pellicule 22 sur une plus grande partie du support 2, voire l'intégralité de sa surface, dès lors que l'on prévoit une étape de masquage des plages de contact ohmiques 4a ou de retrait de matériau de la pellicule 22 au niveau de ces plages.

Le premier mode de réalisation est basé sur une carte à puce dite "à contact", en ce sens qu'elle est prévu pour communiquer avec l'extérieur par les plages de contact ohmiques 4a.

Toutefois, le procédé conforme à la présente invention se prête également à la réalisation de cartes dites "sans contact". Ces cartes, utilisées entre autres pour les systèmes de télépéage ou de contrôle d'accès, permettent d'établir une communication à distance par voie hertzienne entre l'extérieur et la ou les puces 6 de la carte.

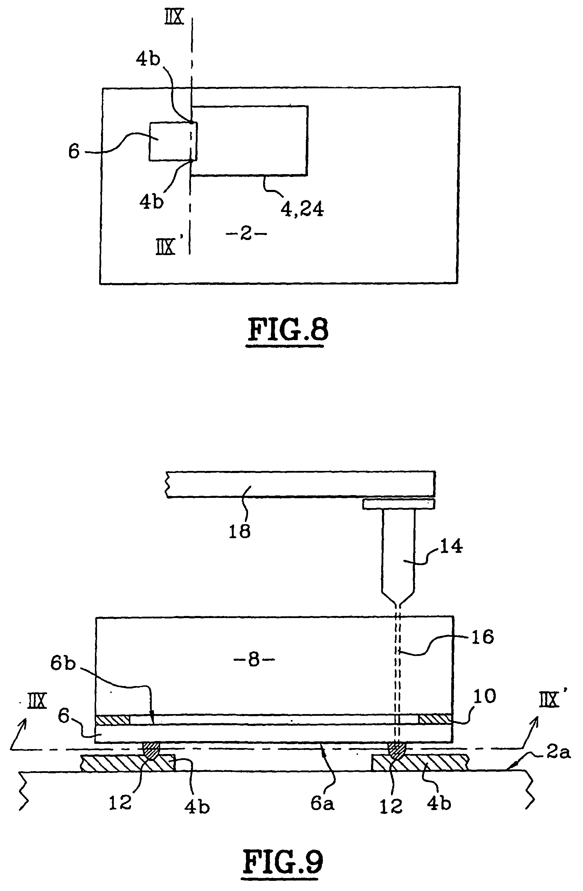

Un exemple d'une telle carte est représenté à la figure 8. La carte 2 est munie d'une antenne 24 ayant ses extrémités 4b reliées à des contacts - ici sous forme de bossages 12 - prévus à cet effet sur la puce 6, comme le montre la figure 9.

Dans l'exemple, deux connexions sont réalisées aux deux extrémités 4b de l'antenne 24 avec deux bossages respectifs 12 sur la face 6a de la puce 6 réalisée en technologie SOI tournée vers le support, comme pour le premier mode de réalisation.

Dans l'exemple, la soudure est réalisée par un faisceau 16 provenant directement d'un laser 14 monté sur un robot positionneur 18, comme décrit précédemment par référence à la figure 5. Il est bien entendu également possible de prévoir un outillage avec plusieurs chemins optiques 20 permettant de réaliser les soudures en parallèle comme décrit par référence à la figure 6.

Les étapes successives à la soudure des bossages 12 avec leurs points de contact respectifs 4b sont les mêmes que celles décrites précédemment, notamment en ce qui concerne le retrait du substrat de verre 8 et la réalisation de la pellicule protectrice 22.

L'invention est remarquable en ce qu'elle permet de réaliser des ensembles de puce montés sur des supports de très faible épaisseur sans avoir recours à une cavité ou autre renfoncement à l'endroit du support destiné à recevoir la puce.

Dans les exemples décrits, basés sur des cartes à puce, il est notamment possible de respecter les normes industrielles ISO 7810 en ce qui concerne la sur-épaisseur maximale admise sur le plan général de la carte (actuellement fixée à 50 microns). En effet, la sur-épaisseur totale due au montage en surface de l'ensemble formant interface de communication 4, puce 6 et pellicule de protection 22 se décompose comme suit :
- épaisseur de la métallisation formant l'interface de communication ≤ 30 µm ;
- épaisseur de la puce 6, issue de la technologie SOI telle que décrite dans le document brevet WO-A-989/02921 = 10 µm (5 µm pour le circuit actif + 5 µm pour les bossages 12);
- épaisseur de la pellicule protectrice = 5 à 15 µm.

La présente invention se prête à de nombreuses variantes.

Aussi, on notera que la puce 6 peut être reliée à d'autre formes de support que le support 2 décrit ci-dessus. Il est en effet tout aussi possible de fixer la puce 6 sur un circuit imprimé simple face (par exemple en rouleau), sur une grille sans diélectrique ou sur tout autre support apte à intégrer une puce 6 mécaniquement et électriquement.

Par ailleurs, le champ d'application de l'invention s'étend bien au-delà du domaine des cartes à puce. Elle peut être mise en oeuvre dans tous les domaines qui font appel à des circuit actifs montés sur des supports, notamment les cartes informatique, les affichages à écran plat, etc...

## Revendications

1. Procédé de fabrication d'un dispositif à puce de circuit intégré ; ce dispositif comportant un support (2) associé à au moins un circuit actif réalisé comme puce (6) avec une face avant (6a) munie d'au moins un plot de connexion (12) et une face opposée (6b) ; ce procédé comprenant les étapes consistant à : prévoir initialement un circuit actif mince (6) qui présente une souplesse mécanique ; maintenir le circuit actif mince (6) solidaire d'un substrat rigidifiant (8) par sa face opposée (6b) dite première face ; montage du circuit actif (6) sur un support de destination (2) ; ce montage comportant les étapes consistant à :
- former dans le plan général d'une face (2a) du support de destination (2) une interface de communication (4) comportant au moins un élément (4b) de connexion avec le circuit actif (6), sur le support de destination (2) ; puis
- présenter l'ensemble comprenant le circuit actif (6) avec son substrat rigidifiant (8), contre l'interface de communication (4), avec le plot de connexion (12) contre un élément de connexion correspondant (4b) ;
- solidariser et coupler électriquement par soudage laser le plot de connexion (12) avec son élément de connexion (4b) ; puis
- retirer le substrat rigidifiant (8) de la face opposée (6b).

2. Procédé selon la revendication 1, **caractérisé en ce que** l'on forme ou réalise l'interface de communication (4) sous forme de plage de contact (4a) ohmique et / ou d'antenne (24), en sur épaisseur sur une portion de surface dans le plan général de la face (2a) du support de destination (2).

3. Procédé selon la revendication 1 ou 2, caractérisé en ce le plot (12) est solidarisé et couplé avec son élément de connexion respectif (4b) au moyen d'un faisceau laser (16), qui traverse le substrat rigidifiant (8) et le circuit actif (6), ces substrat (8) et circuit (6) étant transparents aux longueurs d'ondes utilisées pour le soudage, cette longueur d'onde étant par exemple de 1,06 µm tandis que le plot (12) et /ou l'élément de connexion (4b) est fusible sous l'effet de ce laser.

4. Procédé selon l'une des revendications 1 à 3, **caractérisé en ce que** le support (2) de fixation du circuit actif (6) est en rouleau.

5. Procédé selon l'une des revendications 1 à 4, **caractérisé en ce qu'**il comporte après l'étape de retrait du substrat rigidiflant (8), une étape de dépôt sur la face opposée (6b) d'une pellicule protectrice (22) par exemple d'une épaisseur de 5 à 15 µm et par impression de vernis, dès lors que l'interface de communication comporte au moins une plage de contact ohmique (4a) est éventuellement prévue une étape de masquage ou de retrait du matériau de cette pellicule (22) sur cette plage (4a).

6. Procédé selon l'une des revendications 1 à 5, **caractérisé par** une étape de découpe de l'ensemble comportant le circuit actif (6) et le substrat rigidifiant (8) en ensemble découpé sensiblement aux dimensions du circuit (6), avant l'étape de présentation de cet ensemble (6, 8).

7. Procédé selon l'une des revendications 1 à 6, **caractérisé en ce que** chaque plot (12) est solidarisé avec son élément de connexion respectif (4b) par compression, une force de compression étant appliquée à travers le substrat rigidifiant (8) de l'ensemble (6, 8).

8. Procédé selon la revendication 1 ou 6, caractérisé en ce le plot (12) est solidarisé et couplé avec son élément de connexion respectif (4b) par soudage au moyen d'un faisceau laser (16), qui traverse le substrat rigidifiant (8) et le circuit actif (6), ces substrat (8) et circuit (6) étant transparents aux longueurs d'ondes utilisées pour le soudage, cette longueur d'onde étant par exemple de 1,06 µm tandis que le plot (12) et /ou l'élément de connexion (4b) est fusible sous l'effet de ce laser.

9. Outillage apte à mettre en oeuvre le procédé selon la revendication 8, **caractérisé en ce qu'**il comporte un laser de longueur d'onde par exemple de 1,06 µm, dont le faisceau (16) est transmis par une pluralité de chemins optiques (20), chacun dirigé vers un plot respectif (12) du circuit actif (6), pour réaliser des soudures en parallèle.

10. Outillage selon la revendication 9, **caractérisé en ce que** chaque chemin optique est réalisé par au moins une fibre optique (20).

11. Outillage selon la revendication 9 ou 10, **caractérisé en ce que** les chemins optiques (20) sont intégrés à un outil de positionnement et/ou maintien de l'ensemble (6, 8) vis-à-vis du support de destination (2).

12. Dispositif à puce de circuit intégré, fabriqué selon le procédé conforme à l'une des revendications 1 à 8 et / ou avec un outillage conforme à l'une des revendications 9 à 11 ; ce dispositif comportant un support (2) associé à au moins un circuit actif réalisé comme puce (6) avec une face avant (6a) munie d'au moins un plot de connexion (12) et une face opposée (6b) ; ce circuit actif étant un circuit actif mince (6) qui présente une souplesse mécanique, monté sur un support de destination (2) ; **caractérisé en ce que** ce dispositif comporte une pellicule protectrice (22) d'une épaisseur de 5 à 15 µm couvrant le circuit actif (6) et au moins une partie du support (2), les éléments de connexion et le circuit actif (6) avec ses plots ayant une épaisseur inférieure à 50 µm, ce dispositif étant tel qu'une carte à puce (6), étiquette électronique.

13. Dispositif selon la revendication 12, **caractérisé en ce que** la pellicule protectrice (22) est un vernis imprimé d'étendue limitée, voire sur l'intégralité de la surface du support (2).

## Patentansprüche

1. Herstellungsverfahren einer Vorrichtung mit Chip mit integriertem Schaltkreis; wobei diese Vorrichtung einen wenigstens einem als Chip (6) mit einer mit wenigstens einem Verbindungsklotz (12) ausgestatteten Vorderseite (6a) und einer gegenüber liegenden Seite (6b) realisierten aktiven Schaltkreis zugeordneten Träger (2) umfasst; wobei dieses Verfahren die folgenden Stufen umfasst: zu Beginn Vorsehen eines aktiven dünnen Schaltkreises (6), der eine mechanische Flexibilität aufweist; Aufrecherhalten der festen Verbindung des aktiven dünnen Schaltkreises (6) mit einem versteifenden Substrat (8) durch seine gegenüber liegende, als erste Seite bezeichnete, Seite (6b); Anbringen des aktiven Schaltkreises (6) auf einem Bestimmungsträger (2); wobei dieses Anbringen die folgenden Stufen beinhaltet:
- Bildung einer Kommunikationsschnittstelle (4) mit wenigstens einem Verbindungselement (4b) mit dem aktiven Schaltkreis (6) auf dem Bestimmungsträger (2) in der allgemeinen Ebene (2a) des Bestimmungsträgers (2); anschließendes
- Präsentieren der Struktur mit dem aktiven Schaltkreis (6) mit seinem versteifenden Substrat (8) gegen die Kommunikationsschnittstelle (4), mit Verbindungsklotz (12) gegen ein entsprechendes Verbindungselement (4b);
- feste Befestigung und elektrische Kopplung durch Laserschweißen des Verbindungsklotzes (12) mit seinem Verbindungselement (4b); anschließendes
- Entfernen des versteifenden Substrats (8) von der gegenüber liegenden Seite (6b).

2. Verfahren gemäß Anspruch 1, **dadurch gekennzeichnet, dass** die Kommunikationsschnittstelle (4) in Form von ohmschen Kontaktbereichen (4a) und / oder Antennen (24) in Überdicke auf einem Oberflächenabschnitt in der allgemeinen Ebene der Seite (2a) des Bestimmungsträgers (2) gebildet oder realisiert wird.

3. Verfahren gemäß Anspruch 1 oder 2, **dadurch gekennzeichnet, dass** der Klotz (12) mit seinem jeweiligen Verbindungselement (4b) mittels eines Laserstrahlenbündels (16) fest verbunden oder gekoppelt ist, das das versteifende Substrat (8) und den aktiven Schaltkreis (6) durchquert, wobei dieses Substrat (8) und dieser Schaltkreis (6) für die zum Schweißen verwendeten Wellenlängen transparent sind, wobei diese Wellenlänge zum Beispiel 1,06 µm beträgt, während der Klotz (12) und /oder das Verbindungselement (4b) unter der Wirkung dieses Lasers schmelzbar ist.

4. Verfahren gemäß Anspruch 1 bis 3, **dadurch gekennzeichnet, dass** der Befestigungsträger (2) des aktiven Schaltkreises (6) rollenförmig ist.

5. Verfahren gemäß Anspruch 1 bis 4, **dadurch gekennzeichnet, dass** es nach der Abnahmestufe des versteifenden Substrats (8) eine Auftragstufe einer schützenden dünnen Folie (22), zum Beispiel von einer Dicke von 5 bis 15 um, und durch Lackaufdrucken auf der gegenüber liegenden Seite (6b) umfasst, sobald die Kommunikationsschnittstelle wenigstens einen ohmschen Kontaktbereich (4a) umfasst, ist ebenfalls eine Abdeckoder Abnahmestufe des Materials dieser dünnen Folie (22) auf diesem Bereich (4a) vorgesehen.

6. Verfahren gemäß Anspruch 1 bis 5, **gekennzeichnet durch** eine Ausschneidestufe der den aktiven Schaltkreis (6) das versteifende Substrat (8) als deutlich in den Abmessungen des Schaltkreises (6), vor der Präsentationsstufe dieser Struktur (6, 8) ausgeschnittene Struktur umfassenden Struktur.

7. Verfahren gemäß Anspruch 1 bis 6, **dadurch gekennzeichnet, dass** jeder Klotz (12) mit seinem jeweiligen Verbindungselement (4b) durch Kompression fest verbunden ist, wobei eine Kompressionskraft durch das versteifende Substrat (8) der Struktur (6, 8) angewendet wird.

8. Verfahren gemäß Anspruch 1 oder 6, **dadurch gekennzeichnet, dass** der Klotz (12) mit seinem jeweiligen Verbindungselement (4b) durch Verschweißen mittels eines Laserstrahlenbündels (16) fest verbunden und gekoppelt ist, das das versteifende Substrat (8) und diesen aktiven Schaltkreis (6) durchquert, wobei dieses Substrat (8) und dieser Schaltkreis (6) für die zum Schweißen eingesetzten Wellenlängen transparent sind, wobei diese Wellenlänge zum Beispiel 1,06 µm beträgt, während der Klotz (12) und / oder das Verbindungselement (4b) unter der Wirkung dieses Lasers schmelzbar ist.

9. Zur Umsetzung des Verfahrens gemäß Anspruch 8 geeignetes Werkzeug, **dadurch gekennzeichnet, dass** es einen Laser mit einer Wellenlänge von zum Beispiel 1,06 µm umfasst, dessen Laserstrahlenbündel (16) durch eine Vielzahl von optischen Wegen (20) übertragen wird, wobei jeder davon zur Realisierung der Verschweißungen auf parallele Weise zu einem jeweiligen Klotz (12) des aktiven Schaltkreises (6) geleitet wird.

10. Werkzeug gemäß Anspruch 9, **dadurch gekennzeichnet, dass** jeder optische Weg durch wenigstens eine Lichtleitfaser (20) realisiert wird.

11. Werkzeug gemäß Anspruch 9 oder 10, **dadurch gekennzeichnet, dass** die optischen Wege (20) in ein Positionierungs- und / oder Festhaltewerkzeug der Struktur (6, 8) gegenüber dem Bestimmungsträger (2) integriert sind.

12. Gemäß des Verfahrens nach Anspruch 1 bis 8 und / oder mit einem Werkzeug nach Anspruch 9 bis 11 hergestellte Chipvorrichtung mit integriertem Schaltkreis; wobei diese Vorrichtung einen wenigstens einem als Chip (6) mit einer mit wenigstens einem Verbindungsklotz (12) ausgestatteten Vorderseite (6a) und einer gegenüber liegenden Seite (6b) realisierten aktiven Schaltkreis zugeordneten Träger (2) umfasst; wobei dieser aktive Schaltkreis ein aktiver dünner Schaltkreis (6) ist, der eine mechanische Flexibilität aufweist und auf einem Bestimmungsträger (2) angebracht ist; **dadurch gekennzeichnet, dass** diese Vorrichtung eine schützende dünne Folie (22) mit einer den aktiven Schaltkreis (6) und wenigstens einen Teil des Trägers (2) abdeckenden Dicke von 5 bis 15 µm umfasst, wobei die Verbindungselemente und der aktive Schaltkreis (6) mit seinen Klötzen eine geringere Dicke als 50 µm aufweisen, wobei diese Vorrichtung zum Beispiel eine Chipkarte (6) oder ein elektronisches Etikett ist.

13. Vorrichtung gemäß Anspruch 12, **dadurch gekennzeichnet, dass** die schützende dünne Folie (22) ein gedruckter Lack begrenzten Ausmaßes ist beziehungsweise sich über die gesamte Fläche des Trägers (2) erstreckt.

## Claims

1. A method for manufacturing an integrated circuit chip device; said device comprising a support (2) associated with at least one active circuit produced as a chip (6) with a front face (6a) provided with at least one connection pad (12) and an opposite face (6b); said method comprising the steps consisting of: initially providing a thin active circuit (6) which has mechanical flexibility; holding the thin active circuit (6) secured to a rigidifying substrate (8) by its face (6b) opposite said first face; mounting the active circuit (6) on a destination support (2); said mounting comprising the steps consisting in:
- forming in the general plane of one face (2a) of the destination support (2) a communication interface (4) comprising at least one element (4b) for connection with the active circuit (6), on the destination support (2); then
- presenting the assembly comprising the active circuit (6) with its rigidifying substrate (8) against the communication interface (4), with the connection pad (12) against a corresponding connection element (4b);
- securing and electrically coupling by laser welding the connection pad (12) with its connection element (4b); then
- removing the rigidifying substrate (8) from the opposite face (6b).

2. A method according to Claim 1, **characterised in that** the communication interface (4) is formed or produced in the form of an ohmic contact region (4a) and/or an antenna (24), as an extra thickness on a surface portion in the general plane of the face (2a) of the destination support (2).

3. A method according to Claim 1 or 2, **characterised in that** the pad (12) is secured and coupled with its respective connection element (4b) by means of a laser beam (16) which passes through the rigidifying substrate (8) and the active circuit (6), said substrate (8) and said circuit (6) being transparent at the wavelengths used for the welding, said wavelength being for example 1.06 µm whilst the pad (12) and/or the connection element (4b) can be melted under the effect of said laser.

4. A method according to one of Claims 1 to 3, **characterised in that** the support (2) for fixing the active circuit (6) is on a roll.

5. A method according to one of Claims 1 to 4, **characterised in that** it comprises, after the step of removing the rigidifying substrate (8), a step of depositing, on the opposite face (6b), a protective film (22) for example with a thickness of 5 to 15 µm and by printing of varnish, given that the communication interface comprises at least one ohmic contact region (4a), there is possibly provided a step of masking or removing the material of said film (22) from said region (4a).

6. A method according to one of Claims 1 to 5, **characterised by** a step of cutting out the assembly comprising the active circuit (6) and the rigidifying substrate (8) into a cut-out assembly substantially with the dimensions of the circuit (6), before the step of presenting said assembly (6, 8).

7. A method according to one of Claims 1 to 6, **characterised in that** each pad (12) is secured with its respective connection element (4b) by compression, a compressive force being applied through the rigidifying substrate (8) of the assembly (6, 8).

8. A method according to Claim 1 or 6, **characterised in that** the pad (12) is secured and coupled with its respective connection element (4b) by welding by means of a laser beam (16) which passes through the rigidifying substrate (8) and the active circuit (6), said substrate (8) and said circuit (6) being transparent at the wavelengths used for the welding, said wavelength being for example 1.06 µm whilst the pad (12) and/or the connection element (4b) can be melted under the effect of said laser.

9. A tool suitable for implementing the method according to Claim 8, **characterised in that** it comprises a laser with a wavelength for example of 1.06 µm, whose beam (16) is transmitted by a plurality of optical paths (20), each directed towards a respective pad (12) of the active circuit (6), in order to implement welds in parallel.

10. A tool according to Claim 9, **characterised in that** each optical path is embodied by at least one optical fibre (20).

11. A tool according to Claim 9 or 10, **characterised in that** the optical paths (20) are integrated into a tool for positioning and/or holding the assembly (6, 8) in relation to the destination support (2).

12. An integrated circuit chip device, manufactured according to the method in accordance with one of Claims 1 to 8 and/or with a tool in accordance with one of Claims 9 to 11; said device comprising a support (2) associated with at least one active circuit produced as a chip (6) with a front face (6a) provided with at least one connection pad (12) and an opposite face (6b); said active circuit being a thin active circuit (6) which has mechanical flexibility, mounted on a destination support (2); **characterised in that** said device comprises a protective film (22) with a thickness of 5 to 15 µm covering the active circuit (6) and at least part of the support (2), the connection elements and the active circuit (6) with its pads having a thickness less than 50 µm, said device being such as a smart card (6) or an electronic label.

13. A device according to Claim 12, **characterised in that** the protective film (22) is a printed varnish of limited extent, perhaps even over the entire surface of the support (2).
